# EUROPÄISCHE PATENTSCHRIFT

(11) **EP 2 656 384 B1**
(45) Veröffentlichungstag und Bekanntmachung des Hinweises auf die Patenterteilung: **05.03.2025**
(21) Anmeldenummer: 11805001.2
(22) Anmeldetag: 16.12.2011
(51) Int. Cl.: H01L 23/14, H01L 23/498, H01L 31/02, H01L 33/38

(54) **VERFAHREN ZUR HERSTELLUNG EINES ELEKTRISCHEN ANSCHLUSSTRÄGERS**
METHOD OF MANUFACTURING AN ELECTRIC INTERCONNECTION CARRIER
PROCÉDÉ DE FABRICATION D'UN SUPPORT DE CONNEXION ÉLECTRIQUE

(30) Priorität: 23.12.2010 DE 102010056056
(43) Veröffentlichungstag der Anmeldung: 30.10.2013
(73) Patentinhaber: OSRAM Opto Semiconductors GmbH, 93055 Regensburg (DE)
(72) Erfinder: PLÖSSL, Andreas, 93051 Regensburg (DE)
(74) Vertreter: Epping - Hermann - Fischer
(86) Internationale Anmeldenummer: PCT/EP2011/073136
(87) Internationale Veröffentlichungsnummer: WO 2012/084743

(56) Entgegenhaltungen:
- WO-A1-2011/003907
- WO-A1-2012/010352
- DE-A1- 102008 021 402
- DE-A1- 102009 022 966
- US-A1- 2006 105 496
- US-A1- 2007 080 414
- US-A1- 2010 078 770
- US-A1- 2010 187 694
- Y. K. JEE ET AL: "Zinc and Tin-Zinc Via-Filling for the Formation of Through-Silicon Vias in a System-in-Package", JOURNAL OF ELECTRONIC MATERIALS, vol. 38, no. 5, 1 May 2009 (2009-05-01), pages 685 - 690, XP055026254, ISSN: 0361-5235, DOI: 10.1007/s11664-008-0646-6
- PLOSZL A ET AL: "Silicon-on-insulator: materials aspects and applications", SOLID STATE ELECTRONICS, ELSEVIER SCIENCE PUBLISHERS, BARKING, GB, vol. 44, no. 5, 1 May 2000 (2000-05-01), pages 775 - 782, XP004191708, ISSN: 0038-1101, DOI: 10.1016/S0038-1101(99)00273-7

## Beschreibung

Verfahren zur Herstellung eines elektrischen Anschlussträgers Es wird ein Verfahren zur Herstellung eines elektrischen Anschlussträgers, ein Verfahren zur Herstellung eines optoelektronischen Halbleiterbauelements, ein elektrischer Anschlussträger sowie ein optoelektronisches Halbleiterbauelement angegeben.

Eine zu lösende Aufgabe besteht darin, ein Verfahren zur Herstellung eines elektrischen Anschlussträgers für einen optoelektronischen Halbleiterkörper anzugeben, bei dem Materialschädigungen am hergestellten Anschlussträger vermieden sind.

In der Druckschrift DE 10 2009 022 966 A1 wird ein oberflächenmontierbarer Halbleiterchip auf einem Anschlussträger angegeben.

In der Druckschrift US 2007/0080414 wird ein Verfahren zur Herstellung eines Substrats angegeben, auf dem mikroelektronische Schaltkreise aufgebracht werden können.

Weiterer Stand der Technik ist aus der Druckschrift US 2010/0078770 A1 bekannt.

In einem ersten Schritt des Verfahrens wird eine Trägeranordnung bereitgestellt. Bei der Trägeranordnung kann es sich um einen mechanisch stabilen Träger handeln, auf dessen Außenflächen beispielsweise Bauteile angeordnet und befestigt werden können. Mit anderen Worten ist die Trägeranordnung selbstragend und stellt eine stabile Montage- und/oder Trägergrundlage für die Bauteile dar. Die Trägeranordnung kann nach Art einer Scheibe ausgebildet sein. Vorzugsweise ist eine Ausdehnung der Trägeranordnung in lateraler Richtung groß gegen eine Ausdehnung der Trägeranordnung in vertikaler Richtung. Das heißt, dass die Ausdehnung der Trägeranordnung in lateraler Richtung beispielsweise zumindest fünf Mal größer als die Ausdehnung der Trägeranordnung in vertikaler Richtung ist. "Laterale Richtung" heißt in diesem Zusammenhang eine Richtung parallel zur Haupterstreckungsrichtung der Trägeranordnung. "Vertikale Richtung" ist eine Richtung senkrecht zur Haupterstreckungsrichtung der Trägeranordnung, also zum Beispiel die Dicke der Trägeranordnung. Die Trägeranordnung weist einen Trägerkörper auf, wobei auf einer Außenfläche des Trägerkörpers eine Zwischenschicht angeordnet ist. Weiter ist auf eine dem Trägerkörper abgewandte Außenfläche der Zwischenschicht eine Nutzschicht angeordnet. "Nutzschicht" heißt in diesem Zusammenhang, dass zumindest diese Schicht im fertigen elektrischen Anschlussträger verbleibt und beispielsweise bei der Verbauung des elektrischen Anschlussträgers in einem optoelektronischen Bauelement eine elektrische und/oder mechanische Funktion übernimmt.

Vorzugsweise ist das Material der Zwischenschicht verschieden von dem Material der Nutzschicht. In diesem Fall ist das Material der Nutzschicht nicht identisch mit dem Material der Zwischenschicht. Die Zwischenschicht ist elektrisch isolierend. Die Nutzschicht und die Zwischenschicht können sich zumindest in ihren chemischen und/oder physikalischen Eigenschaften voneinander unterscheiden.

In einem nächsten Schritt des Verfahrens werden zumindest zwei in lateraler Richtung beabstandet zueinander angeordnete Öffnungen in die Nutzschicht über eine dem Trägerkörper abgewandte Außenfläche der Nutzschicht eingebracht, wobei sich die Öffnungen in vertikaler Richtung vollständig durch die Nutzschicht hindurch erstrecken. Zum Beispiel werden die Öffnungen in die Nutzschicht mittels zumindest eines trocken- und/oder nasschemischen Ätzprozesses eingebracht. Beispielsweise ist die Zwischenschicht im Vergleich zur Nutzschicht unter Verwendung des gleichen Ätzmittels im Wesentlichen nicht ätzbar. "Im Wesentlichen nicht ätzbar" heißt in diesem Zusammenhang, dass die Zwischenschicht unter Verwendung eines Ätzmittels eine Ätzrate aufweist, welche höchstens 20 %, bevorzugt weniger als 10 % einer Ätzrate der Nutzschicht, unter Verwendung des gleichen Ätzmittels, beträgt. Mit anderen Worten wird in diesem Fall während des Ätzens durch die Nutzschicht hindurch geätzt und der Ätzprozess aufgrund der Materialeigenschaften und der damit einhergehenden geringen oder nicht vorhandenen Ätzrate in der Zwischenschicht zum Erliegen gebracht. Bei der Zwischenschicht handelt es sich in diesem Fall um eine Ätzstoppschicht. Mit anderen Worten geht ein derartiges Einbringen von Öffnungen in die Nutzschicht mit einem Ätzprozess hoher Ätzselektivität zwischen der Nutzschicht und der Zwischenschicht einher. Alternativ oder zusätzlich kann der Ätzprozess in der Zwischenschicht auch mittels einer Ätzendpunkterkennung unter- oder abgebrochen werden. Insbesondere kann dies bei ähnlichen oder gleichen Ätzraten der Nutzschicht und der Zwischenschicht nützlich sein, da der Ätzprozess in diesem Fall nicht zwangsläufig innerhalb der Zwischenschicht von selbst zum erliegen kommt sondern von außen vorgebbar unter- oder abgebrochen werden muss. Dazu könnte beispielsweise ein Abklingen eines mit der Nutzschicht und/oder dem Ätzprozess korrelierten (Ätz)-Signals oder ein Ansteigen eines mit der Zwischenschicht und/oder dem Ätzprozess zusammenhängenden (Ätz)-Signals genutzt werden um den Ätzprozess rechtzeitig zu unterbrechen und/oder zu stoppen.

Jede Öffnung weist eine Bodenfläche auf. Zum Beispiel weist jede Öffnung zumindest eine durchgehende und zusammenhängende Seitenfläche sowie eine der Bodenfläche gegenüberliegende Öffnung auf. Die Bodenfläche ist vollständig durch die Zwischenschicht gebildet, wobei die Seitenfläche zumindest stellenweise durch die Nutzschicht gebildet ist.

In einem nächsten Schritt werden Seitenflächen der Öffnungen und die dem Trägerkörper abgewandte Außenfläche der Nutzschicht elektrisch isoliert. Das heißt, dass direkt auf den Seitenflächen der Öffnungen sowie der dem Trägerkörper abgewandten Außenfläche der Nutzschicht kein elektrischer Strom geführt werden kann.

In einem nächsten Schritt wird elektrisch leitfähiges Material zumindest stellenweise in den Öffnungen angeordnet, wobei nach Fertigstellung des Anschlussträgers das elektrisch leitfähige Material in seinem Verlauf entlang der Außenfläche der Nutzschicht in der lateralen Richtung zwischen benachbarten Öffnungen zumindest eine Unterbrechung aufweist. Mit anderen Worten verbindet das elektrisch leitfähige Material in lateraler Richtung benachbarte Öffnungen nicht durchgehend miteinander. Zum Beispiel sind die Öffnungen vollständig mit dem elektrisch leitfähigen Material ausgefüllt. Beispielsweise isoliert die Unterbrechung in lateraler Richtung voneinander benachbart in den Öffnungen angeordnetes elektrisch leitfähiges Material voneinander. In einem ersten Schritt des Verfahrens wird eine Trägeranordnung bereitgestellt, die einen Trägerkörper, eine auf einer Außenfläche des Trägerkörpers angeordnete Zwischenschicht und eine auf einer dem Trägerkörper abgewandten Außenfläche der Zwischenschicht angeordnete Nutzschicht aufweist. In einem nächsten Schritt werden zumindest zwei in lateraler Richtung beabstandet zueinander angeordnete Öffnungen in der Nutzschicht über eine dem Trägerkörper abgewandte Außenfläche der Nutzschicht eingebracht, wobei sich die Öffnungen in vertikaler Richtung vollständig durch die Nutzschicht hindurch erstrecken. In einem weiteren Schritt werden Seitenflächen der Öffnungen und die dem Trägerkörper abgewandte Außenfläche der Nutzschicht elektrisch isoliert. Weiter wird in einem nächsten Schritt elektrisch leitfähiges Material zumindest stellenweise in den Öffnungen angeordnet, wobei nach Fertigstellung des Anschlussträgers das elektrisch leitfähige Material in seinem Verlauf entlang der Außenfläche der Nutzschicht in der lateralen Richtung zwischen benachbarten Öffnungen zumindest eine Unterbrechung aufweist.

Das hier beschriebene Verfahren zur Herstellung eines elektrischen Anschlussträgers beruht dabei unter anderem auf der Erkenntnis, dass das Einbringen von Öffnungen in einen Trägerkörper, welcher zur späteren elektrischen Kontaktierung eines optoelektronischen Bauelements dienen kann, mit Schädigungen am oder im Trägerkörper verbunden sein kann. Werden die Öffnungen beispielsweise mittels eines Ätzprozesses in den Träger eingebracht, kann ein derartiger Ätzprozess zu Materialschädigungen im Trägerkörper insbesondere im Bereich von Bodenflächen der Öffnungen führen. Da ein derartiger Trägerkörper Bestandteil des späteren optoelektronischen Bauelements bleiben kann, weist ebenso das optoelektronische Bauelement derartige Schädigungen an seinem Trägerkörper auf. Beispielsweise kann dies zu einem optoelektronischen Bauelement führen, dessen optische Ausgangsleistung und/oder Belastbarkeit im Betrieb reduziert ist.

Um nun ein Verfahren zur Herstellung eines elektrischen Anschlussträgers anzugeben, bei dem derartige Materialschädigungen im Trägerkörper vermieden werden, macht das hier beschriebene Verfahren unter anderem von der Idee Gebrauch, auf einem Trägerkörper zunächst eine Zwischenschicht und auf diese Zwischenschicht eine Nutzschicht anzuordnen. Mit anderen Worten ist die Zwischenschicht zwischen der Nutzschicht und dem Trägerkörper angeordnet. Die Zwischenschicht kann daher ein Puffer und/oder Abstandshalter zwischen dem Trägerkörper und der Nutzschicht sein.

Werden nun in die Nutzschicht beispielsweise mittels eines Ätzverfahrens die Öffnungen eingebracht, kann die Zwischenschicht als ein Ätzstopp wirken, durch den der Ätzprozess zum Erliegen gebracht wird. Mit anderen Worten wirkt die Zwischenschicht als der Ätzabschluss (auch Sacklochabschluss), sodass eventuelle Schäden zum Beispiel im Bereich der Bodenflächen der Öffnungen, welche durch den Ätzabschluss verursacht sein können, anstatt in der Nutzschicht lediglich in der Zwischenschicht durch den Ätzprozess verursacht werden können. Mit anderen Worten werden Schädigungen in der Nutzschicht vermieden. Um beispielsweise die Nutzschicht in einem späteren optoelektronischen Bauelement verbaubar zu machen, werden in einem nächsten Schritt Seitenflächen der Öffnungen und eine dem Trägerkörper abgewandte Außenfläche der Nutzschicht elektrisch isoliert. Auf der Außenfläche wird ein Halbleiterkörper des späteren optoelektronischen Halbleiterbauelements aufgebracht, wobei der Halbleiterkörper über das in den Öffnungen angeordnete elektrisch leitfähige Material elektrisch kontaktiert ist. Gemäß zumindest einer Ausführungsform des Verfahrens wird das elektrische Isolieren mittels zumindest eines thermischen Oxidationsverfahrens durchgeführt. Mittels eines derartigen Verfahrens können die Seitenflächen der Öffnungen und die dem Trägerkörper abgewandte Außenfläche der Nutzschicht besonders einfach und kostengünstig elektrisch isoliert werden. Beispielsweise werden dazu die Seitenflächen der Öffnungen und die Außenfläche erhitzt, sodass beispielsweise das Material der Nutzschicht oberflächenoxidiert wird.

Gemäß zumindest einer Ausführungsform des Verfahrens wird das elektrische Isolieren mittels eines Beschichtungsverfahrens durchgeführt, wobei abgeschiedene Schichten aus zumindest einem der folgenden Materialien AlN, Al₂O₃, SiO₂, Si₃N₄, SrO, HfO, HfO₂, ZrO, ZrO₂ gebildet sind oder zumindest eines der Materialien enthalten. Insbesondere können die elektrisch isolierenden Schichten beispielsweise durch chemische Gasphasenabscheidung (zu engl.chemical vapour deposition, CVD) und/oder Atomlagenabscheidung (zu engl. atomic layer deposition, ALD) aufgebracht sein.

Gemäß zumindest einer Ausführungsform ist der Trägerkörper mit einem Silizium und die Zwischenschicht mit einem Oxid des Siliziums und/oder einem Nitrid des Siliziums gebildet. Zum Beispiel ist ein derartiger Trägerkörper in der Druckschrift "Silicon-on-insulator: materials aspects and applications, Andreas Plössl, Gertrud Kräuter, Solid-State Electronics layer 44 (2000) 775-782" beschrieben.

Gemäß zumindest einer Ausführungsform ist die Zwischenschicht mit zumindest eines der folgenden Materialien SiO₂, Si₃N₄, SrO, HfO, HfO₂, ZrO, ZrO₂ gebildet oder enthält zumindest eines dieser Materialien.

Gemäß zumindest einer Ausführungsform des Verfahrens ist die Nutzschicht mit zumindest einem der Materialien Si, AlN, GaN, Ge, GaAs gebildet oder enthält zumindest eines der Materialien. Beispielsweise sind die Nutzschicht und der Trägerkörper mit dem gleichen Material, beispielsweise Si, gebildet. In diesem Fall ist eine derartige Trägeranordnung besonders kostengünstig. Ist die Nutzschicht mit GaN gebildet kann die Zwischenschicht und/oder der Trägerkörper beispielsweise mit Si gebildet sein. Vorteilhaft weisen GaN und Si aneinander angepasste thermische Ausdehnungskoeffizienten auf, sodass es innerhalb der Trägeranordnung, beispielsweise während eines Erwärmens der Trägeranordnung, innerhalb der Trägeranordnung zu möglichst geringen Zug- und/oder Druckverspannungen kommt.

Ebenso kommt statt des Si als Material für den Trägerkörper und/oder die Zwischenschicht Saphir in Frage. Ebenso kann zum Beispiel die Zwischenschicht mit einer oder mehreren Teilschichten gebildet sein, die jeweils zum Beispiel mit einem der folgenden Materialien gebildet sind: SiO₂, Si₃N₄, SrO, HfO, HfO₂, ZrO, ZrO₂. In diesem Fall kann auf der Zwischenschicht eine weitere Zwischenschicht angeordnet sein, welche zum Beispiel mit SiO₂ gebildet ist. Ist die Nutzschicht beispielsweise mit Ge gebildet kann als Material für den Trägerkörper und/oder die Zwischenschicht Ge, GaAs oder Saphir in Frage kommen. In diesem Fall ist es möglich, dass das elektrische Isolieren der Seitenflächen statt mittels einer thermischen Oxidation beispielsweise mittels Abscheidung von zumindest einer elektrisch isolierenden Schicht zumindest auf die Seitenflächen der Nutzschicht erfolgt.

Gemäß zumindest einer Ausführungsform des Verfahrens wird das elektrisch leitfähige Material in Form einer Schmelze in die Öffnungen eingebracht und anschließend ausgehärtet, wobei das elektrisch leitfähige Material mit zumindest einem der Materialien Al, Zn , Cu, Ag, Si, Cd, Ga, In, Tl, Sn, Pb, Bi, Po gebildet ist oder zumindest eines der Materialien enthält. Beispielsweise ist ein derartiges Einbringen von elektrisch leitfähigem Material in die Öffnungen für den Fall von Zn in der Druckschrift "Zinc and Tin-Zinc Via Filling for the Formation of Through-Silicon Vias in a System-in-Package, Journal of ELECTRONIC MATERIALS, Vol. 38, No. 5, 2009" beschrieben. Ist das elektrisch leitfähige Material mit einem Halbleitermaterial gebildet, kann dieses dotiert sein. Ebenso kann es sich bei dem elektrisch leitfähigen Material um Legierungen und/oder um elektrisch leitfähige Metallpasten handeln. Liegt das elektrisch leitfähige Material in Form einer Metallpaste vor, kann das Aushärten der Metallpaste isotherm erfolgen.

Gemäß zumindest einer Ausführungsform des Verfahrens wird das elektrisch leitfähige Material in Form einer Schmelze in die Öffnungen eingebracht und anschließend ausgehärtet, wobei das elektrisch leitfähige Material zumindest ein binäres eutektisches System umfasst. Beispielsweise umfasst das binäre eutektische Material Legierungen wie zum Beispiel: AuSn, AuSi, AuGe, AuSb, AlGe und AlZn.

Gewünschte physikalische und/oder technische Eigenschaften des elektrisch leitfähigen Materials sind eine hohe elektrische und thermische Leitfähigkeit, eine möglichst genau Anpassung an die thermischen Ausdehnungseigenschaften der Nutzschicht, sowie eine möglichst gute Haftung an der Nutzschicht. Weitere Kriterien zur Auswahl des entsprechenden Materials können Viskosität, Oberflächenspannung, Reaktivität oder Oxidationsanfälligkeit des elektrisch leitfähigen Materials sein.

Ist die Nutzschicht zusammen mit dem elektrisch leitfähigen Material in einem Halbleiterbauelement verbaut, kann eine möglichst hohe elektrische und thermische Leitfähigkeit zur Vermeidung von Energieverlusten in der Stromzuführung innerhalb des Halbleiterbauelements und zu einer möglichst effektiven Abfuhr von Verlustleistung aus dem Halbleiterbauelement führen.

In nachstehender Tabelle sind die einzelnen physikalischen und/oder technischen Eigenschaften von Zink und Aluminium gegenübergestellt:

| | **Aluminium** | **Zink** |
|---|---|---|
| **Schmelzpunkt [°C]** | 660,4 | 419,6 |
| **Viskosität [mPa s]** | 1,2 | 3,5 |
| **Oberflächenenergie [J/m²]** | 1,07 | 0,8 |
| **Spezifischer elektrischer Widerstand [µΩ cm]** | 2,7 | 6, 0 |
| **Wärmeleitfähigkeit [W/m K]** | 235 | 120 |
| **Linearer thermischer Ausdehnungskoeffizient [10⁻⁶ K⁻¹]** | 23,1 | 30,2 |

Beispielsweise weisen Cu und Ag eine hohe elektrische und thermische Leitfähigkeit auf. Ist das elektrisch leitfähige Material mit Zn, Si, Cd, Ga, In, Tl, Sn, Pb, Bi, Po, AuSn gebildet weist das elektrisch leitfähige Material eine niedrige Schmelztemperatur auf, wodurch die Nutzschicht beispielsweise während des Befüllens der Öffnungen möglichst wenig (hitze)-geschädigt wird. Andererseits sind die Schmelztemperaturen jedoch hoch genug, sodass bei einer Verbauung der Nutzschicht in einem späteren Halbleiterbauelement, beispielsweise während eines Lötprozesses, das elektrisch leitfähige Material nicht aufschmilzt.

Gemäß zumindest einer Ausführungsform des Verfahrens wird das elektrisch leitfähige Material in Form einer Schmelze in die Öffnungen eingebracht, wobei die Isolationsschicht im Bereich der Öffnungen zusätzlich durch eine Metalllage benetzt wird. Durch die Benetzung der Isolationsschicht mit der Metalllage kann man die Benetzungseigenschaften für das elektrisch leitfähige Material auf der Isolationsschicht unterschiedlich ausgestalten und verbessern.

Die Metalllage kann hinsichtlich ihrer Benetzung durch das Füllmaterial ausgewählt werden. Es können physikalische oder chemische Dampfphasenabscheideverfahren wie Zerstäuben (engl. sputtering), Dampfen und ALD (Atomic Layer Deposition) zum Aufbringen der Metalllage verwendet werden, wobei insbesondere die Dampfphasenabscheideverfahren in Kombination mit einem photolithographischen Strukturierverfahren angewendet werden kann.

Mögliche Materialien zur Bildung der Metalllage sind insbesondere Ni oder Nb, wobei auch eine mehrlagige Kombination wie Ti/Ni/Au, Cr/Pt/Au, Ti/TiN/Ni/Pd/Au oder TaN/Pt/Au zur Beschichtung der Isolationsschicht eingesetzt werden können, wobei die Schichtenfolge der Metalllagen von den oben genannten Beispielen abweichen kann. Beispielsweise kann bei der Mehrlagenvariante jede Einzelschicht eine bestimmte Funktion übernehmen. Zum Beispiel eignen sich Ti oder Cr zur Haftvermittlung zum Untergrund, Ni, Pd, oder Pt für eine Benetzungsfunktion und Au für eine leicht benetzbare Abdeckung, die die Oxidation oder Kontamination der unteren Metalllage bei der mehrlagigen Kombination verhindern oder zumindest vermindern soll. Im Fall von AuSn-Schmelze zum Füllen der Öffnungen wäre insbesondere Ti/Pt/Au eine vorteilhafte Schichtenabfolge zur Bildung der Metalllage.

Gemäß zumindest einer Ausführungsform ist das elektrisch leitfähige Material ein elektrisch leitfähiger Kleber. Beispielsweise ist der Kleber mit einem Matrixmaterial gebildet, in das Metallpartikel oder andere elektrisch leitfähige Partikel eingebracht sind, wobei das Matrixmaterial nach dem Einfüllen in die Öffnungen aushärten kann.

Gemäß zumindest einer Ausführungsform des Verfahrens überragt nach dem Aushärten das elektrisch leitfähige Material die Nutzschicht in vertikaler Richtung. Das heißt, dass das elektrisch leitfähige Material aus der Nutzschicht in vertikaler Richtung hervorragt und über die Nutzschicht erhaben ist. In diesem Fall können die Öffnungen mit dem elektrisch leitfähigen Material überfüllt sein und das aus den Öffnungen austretende, überschüssige elektrisch leitfähige Material mit der dem Trägerkörper abgewandten Außenfläche der Nutzschicht in direktem Kontakt stehen.

Alternativ können die Öffnungen auch nur teilweise mit dem elektrisch leitfähigen Material befüllt sein. Mit anderen Worten sind die Öffnungen in diesem Fall unterfüllt. Das heißt, die Nutzschicht überragt das elektrisch leitfähige Material in vertikaler Richtung. Eine derartige Unterfüllung kann vermieden oder behoben werden, indem eine vertikale Ausdehnung der Nutzschicht und/oder der Zwischenschicht entsprechend gering gewählt werden, oder die Nutzschicht und/oder die Zwischenschicht mittels eines selektiven Ätzprozesses bis auf Höhe des elektrisch leitfähigen Materials zurückgezogen werden.

Gemäß zumindest einer Ausführungsform wird in einem nächsten Schritt auf die dem Trägerkörper abgewandte Außenfläche der Nutzschicht zumindest stellenweise zumindest eine Polierstoppschicht aufgebracht, wobei dem Trägerkörper abgewandte Außenflächen des elektrisch leitfähigen Materials zumindest stellenweise frei von der Polierstoppschicht sind und die Polierstoppschicht mit zumindest einem der Materialien SiO₂, Si₃N₄, SrO, HfO, HfO₂, ZrO, ZrO₂ gebildet ist oder zumindest eines der Materialien enthält. Beispielsweise wird lediglich auf die freiliegende Außenfläche der Nutzschicht die Polierstoppschicht aufgebracht, wobei die Polierstoppschicht in einer Draufsicht auf die Außenfläche der Nutzschicht das elektrisch leitfähige Material vollständig umrandet und umschließen kann.

Beispielsweise überragt nach dem Aufbringen der Polierstoppschicht auf der Außenfläche der Nutzschicht das elektrisch leitfähige Material in vertikaler Richtung ebenso die Polierstoppschicht. Mit anderen Worten ragt auch in diesem Fall das elektrisch leitfähige Material aus der Polierstoppschicht in vertikaler Richtung hervor. Ebenso ist es möglich, dass die Polierstoppschicht vor dem Erzeugen der Öffnungen in der Nutzschicht und/oder vor dem Anordnen des elektrisch leitfähigen Materials auf die dem Trägerkörper abgewandte Außenfläche der Nutzschicht zumindest stellenweise aufgebracht wird. "Polierstoppschicht" heißt in diesem Zusammenhang, dass unter Anwendung eines chemischen und/oder mechanischen Polierschritts die Polierstoppschicht im Vergleich zum elektrisch leitfähigen Material wesentlich schlechter oder gar nicht abgetragen und/oder poliert werden kann. Beispielsweise weist nach Anwendung des Polierschritts lediglich das elektrisch leitfähige Material Spuren eines Materialabtrags auf.

Weiter kann die Polierstoppschicht basierend auf oben genannten Materialien auch als elektrische Isolationsschicht fungieren. Mit anderen Worten übernimmt die Polierstoppschicht dann eine Doppelfunktion. Das heißt, sie wirkt elektrisch isolierend und stoppt den chemischen und/oder mechanischen Polierschritt, wobei primär besonders an den Kanten der dem Trägerkörper abgewandte Außenfläche der Nutzschicht vor mechanischen Beschädigungen vorgebeugt werden soll. In diesem Fall stellt das Aufbringen einer zusätzlichen Polierstoppschicht lediglich einen weiteren Schutz für die dem Trägerkörper abgewandte Außenfläche der Nutzschicht zur bereits bestehenden Isolationsschicht beziehungsweise Polierstoppschicht dar. Erfüllt also die Polierstoppschicht die Doppelfunktion kann von dem Aufbringen einer weiteren Polierstoppschicht abgesehen werden.

Gemäß zumindest einer Ausführungsform überragt nach Anwendung zumindest eines Polierschritts zumindest auf das elektrisch leitfähige Material das elektrisch leitfähige Material die Polierstoppschicht in vertikaler Richtung nicht.

Beispielsweise bildet in diesem Fall das elektrisch leitfähige Material zusammen mit einer dem Trägerkörper abgewandten Außenfläche der Polierstoppschicht eine ebene Fläche aus. Vorteilhaft können bei einer späteren Aufbringung eines Halbleiterkörpers auf die Polierstoppschicht und auf das elektrisch leitfähige Material elektrische und/oder mechanische Anschlussprobleme des Halbleiterkörpers am elektrisch leitfähigen Material vermieden werden.

Gemäß zumindest einer Ausführungsform wird nach dem Anordnen des elektrisch leitfähigen Materials der Trägerkörper von der Zwischenschicht entfernt. Beispielsweise geschieht das Entfernen des Trägerkörpers mittels Einstrahlung von hochenergetischem Laserlicht beispielsweise auf die Zwischenschicht, welche durch das Laserlicht zumindest teilweise zerstört wird (auch Laser Lift-off). Ebenso ist denkbar, dass der Trägerkörper durch zumindest stellenweises Ätzen und/oder mechanischem Schleifen der Zwischenschicht und/oder des Trägerkörpers selbst entfernt wird. Zusätzlich ist denkbar, dass noch etwaige nach dem Entfernen des Trägerkörpers verbleibende Reste der Zwischenschicht von der Nutzschicht mittels weiteren Polierens entfernt werden. Nach dem Entfernen des Trägerkörpers und gegebenenfalls der Zwischenschicht verbleibt im fertigen Anschlussträger lediglich die Nutzschicht als ein Trägermaterial des elektrischen Anschlussträgers.

Gemäß zumindest einer Ausführungsform wird auf das Entfernen des Trägerkörpers von der Zwischenschicht vor der Kontaktierung des optoelektronischen Halbleiterkörpers verzichtet. Das heißt, dass der optoelektronische Halbleiterkörper mit der Trägeranordnung kombiniert werden kann, bevor der Trägerköper von der Nutzschicht entfernt worden ist und nachdem das elektrisch leitfähige Material die Öffnungen befüllt und zumindest stellenweise ein durchgehender Kontakt zwischen elektrisch leitfähigen Material und optoelektronischen Halbleiterkörper ausgebildet werden kann. Insbesondere ist es auch möglich den optoelektronischen Halbleiterkörper erst nach dem Aufbringen des Anschlussträgers über eine zum Kontaktträger zugewandte Außenfläche der Nutzschicht (Kontaktfläche) auf einen Bauteilträger anzubringen.

Gemäß zumindest einer Ausführungsform wird nach dem Anordnen des elektrisch leitfähigen Materials der Trägerkörper von der Zwischenschicht entfernt. Ätzt beispielsweise zusätzlich zur Nutzschicht zumindest teilweise in die Zwischenschicht hinein, um die zueinander lateral beabstandete Öffnungen in den Anschlussträger einzubringen, so kann die verbleibende Zwischenschicht zur Kantenisolierung an der dem Trägerkörper zugewandten Seite der Nutzschicht beitragen. Hierbei erfolgt das Entfernen des Trägerkörpers wiederum mittels Laser Lift-Off Verfahren, wobei der Trägerkörper aus einem dem Laser Lift-Off Verfahren zugänglichen Material ausgebildet ist und insbesondere um einen nachfolgenden trocken- oder nasschemischen Ätzprozess ergänzt werden kann, um mögliche Rückstände der Zwischenschicht zu entfernen. Alternativ werden der Trägerkörper sowie die Zwischenschicht beispielsweise durch mechanisches Schleifen planar abgetragen, wobei ein anschließender trocken- oder nasschemischer Ätzprozess zur Entfernung möglicher Rückstände der Zwischenschicht und/oder des Trägerkörpers eingesetzt werden kann, bis das elektrisch leitfähige Material freiliegt und mit der verbleibenden Zwischenschicht eine Grenzfläche ausbildet. Auch kann das Entfernen des Trägerkörpers und der Zwischenschicht nur durch Ätzen erfolgen, wobei keine Kombination mit anderen materialabtragenden Prozessen stattfindet. Die sich bildende Grenzfläche kann insbesondere als Anschlussfläche zu einem Bauteilträger und/oder Kontaktträger eingesetzt werden.

Gemäß zumindest einer Ausführungsform umfasst der elektrische Anschlussträger die Anschlussfläche, wobei auf der Anschlussfläche eine Kontaktschicht ausgebildet ist. Zum Beispiel kann sich dabei die Kontaktschicht über einen Großteil der Anschlussfläche erstrecken. "Großteil" bedeutet im vorliegenden Zusammenhang, dass die Kontaktschicht die Anschlussfläche mit einer Flächenbedeckung von wenigsten 50%, insbesondere wenigstens 75 % bedeckt, wobei insbesondere Isolationsbereiche, zum Beispiel in Form eines Isolationsspalts, die Kontaktschicht in elektrisch zueinander isolierend ausgebildete Bereiche oder Flächen trennt. Die Isolationsbereiche umfassen dabei insbesondere ein isolierendes Material. Dabei kann die Kontaktschicht beispielsweise auf einer hexagonalen oder rechteckigen Anschlussfläche eines optoelektronischen Bauelements ausgebildet sein, wobei die Kontaktschicht beispielsweise durch Trennung mit dem Isolationsspalt symmetrisch und/oder asymmetrisch ausgebildet sein kann.

Es wird darüber hinaus ein Verfahren zur Herstellung eines optoelektronischen Halbleiterbauelements angegeben.

Gemäß zumindest einer Ausführungsform des Verfahrens wird in einem ersten Schritt ein elektrischer Anschlussträger bereitgestellt, der durch ein Verfahren, wie es in einer oder mehreren der hier beschriebenen Ausführungsformen beschrieben ist, hergestellt ist. Das heißt, die für das hier beschriebene Verfahren zur Herstellung des elektrischen Anschlussträgers ausgeführten Merkmale sind auch für das hier beschriebene Verfahren zur Herstellung des optoelektronischen Halbleiterbauelements offenbart und umgekehrt.

In einem weiteren Schritt des Verfahrens wird auf der Außenfläche der Nutzschicht zumindest ein Halbleiterkörper angeordnet, der zumindest eine zur Erzeugung oder zur Detektion von elektromagnetischer Strahlung geeignete aktive Zone umfasst, wobei der Halbleiterkörper mit dem elektrisch leitfähigen Material elektrisch leitend verbunden ist. Beispielsweise sind einem Halbleiterkörper zumindest jeweils zwei in lateraler Richtung benachbart angeordnete Öffnungen zugeordnet, in denen das elektrisch leitfähige Material angeordnet ist. In diesem Fall kann der Halbleiterkörper elektrische Kontaktstellen aufweisen, welche elektrisch leitend mit den dem Trägerkörper abgewandten Außenflächen des elektrisch leitfähigen Materials verbunden sind.

Gemäß zumindest einer Ausführungsform des Verfahrens wird in einem weiteren Schritt auf der Außenfläche der Nutzschicht zumindest ein Halbleiterkörper angeordnet, der zumindest eine zur Erzeugung oder zur Detektion von elektromagnetischer Strahlung geeignete aktive Zone umfasst, wobei die aktive Zone durch ein weiteres elektrisch leitfähige Material durchbrochen ist. Der Durchbruch bildet insbesondere mit der Unterseite des optoelektronischen Halbleiterkörpers eine Grenzfläche aus verbindet zum Beispiel einen n-leitenden Bereich des optoelektronischen Halbleiterkörpers elektrisch leitend mit dem elektrisch leitfähigen Material des Anschlussträgers.

Gemäß zumindest einer Ausführungsform basiert der Halbleiterkörper auf einem III-Nitrid Halbleitermaterial.

"III-Nitrid Halbleitermaterial" bedeutet im vorliegenden Zusammenhang, dass der Halbleiterkörper ein Nitrid Halbleitermaterial, vorzugsweise AlₙGaₘIn₁₋ₙ₋ₘN aufweist oder aus diesem besteht, wobei 0 ≤ m ≤ 1, 0 ≤ n ≤ 1 und m + n ≤ 1.

Gemäß zumindest einer Ausführungsform basiert der Halbleiterkörper auf einem III-Phosphid Halbleitermaterial. "III-Phosphid Halbleitermaterial" bedeutet im vorliegenden Zusammenhang, dass der Halbleiterkörper ein Phosphid Halbleitermaterial, vorzugsweise AlₙGaₘIn₁₋ₙ₋ₘP oder AsₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen. Der Einfachheit halber beinhaltet obige Formel jedoch nur die wesentlichen Bestandteile des Kristallgitters (Al, Ga, In bzw. N, P, As, Sb), auch wenn diese teilweise durch geringe Mengen weiterer Stoffe ersetzt sein können. Der Halbleiterkörper besteht insbesondere aus AlGaInP, AlGaInN oder AlGaInAs oder aus einer Kombination, wie zum Beispiel aus Stapeln aus III-P und III-AS basierenden Teilzellen.

Gemäß zumindest einer Ausführungsform des Verfahrens durchdringt das weitere elektrisch leitfähige Material die aktive Zone des optoelektronischen Halbleiterkörpers und ein dotierter Bereich des optoelektronischen Halbleiterkörpers ist elektrisch leitend mit dem elektrisch leitfähigen Material des elektrischen Anschlussträgers angeschlossen. Das weitere elektrisch leitfähige Material durchdringt dabei den optoelektronischen Halbleiterkörper derart, dass das weitere elektrisch leitfähige Material mit der Unterseite des optoelektronischen Halbleiterkörpers eine weitere Grenzfläche ausbildet, den aktiven Bereich durchdringt und mit dem dotierten Bereich angeschlossen ist. Dabei kann es sich bei dem dotierten Bereich um einen n-leitenden oder p-leitenden Bereich des optoelektronischen Halbleiterkörpers handeln, wobei beispielsweise der n-leitende Bereich durch die aktive Zone von dem p-leitenden Bereich getrennt ist. Die sich bildende weitere Grenzfläche steht insbesondere mit dem elektrisch leitfähigen Material des elektrischen Anschlussträgers im direkten Kontakt. Mit anderen Worten bildet das weitere elektrische leitfähige Material des optoelektronischen Halbleiterkörpers mit dem elektrisch leitfähigen Material des elektrischen Anschlussträgers eine durchgängige elektrische Verbindung aus. Das weitere elektrisch leitende Material kann dabei die gleiche Zusammensetzung wie das elektrisch leitende Material aufweisen.

In der Nutzschicht ist zumindest eine Schutzdiodenstruktur ausgebildet, welche mit dem Halbleiterkörper elektrisch verschaltet ist. Beispielsweise ist die Schutzdiodenstruktur in die Nutzschicht integriert. Zum Beispiel bildet dann die dem Trägerkörper abgewandte Außenfläche der Nutzschicht zusammen mit einer dem Trägerkörper abgewandten Außenfläche der Schutzdiodenstruktur eine ebene Fläche aus. Mit anderen Worten ragt die Schutzdiodenstruktur in diesem Fall nicht aus der Nutzschicht in vertikaler Richtung hervor.

Gemäß zumindest einer Ausführungsform ist in der Nutzschicht zumindest eine Schutzdiodenstruktur ausgebildet, welche mit dem Halbleiterkörper elektrisch verschaltet ist. Beispielsweise ist die Schutzdiodenstruktur in die Nutzschicht integriert, dabei kann die dem Trägerkörper zugewandten Außenfläche der Nutzschicht zusammen mit einer dem Trägerkörper zugewandten Außenfläche der Schutzdiodenstruktur eine ebene Fläche ausbilden. Hierzu ist es erforderlich, dass vor dem Aufbringen der Nutzschicht auf der dem Trägerkörper abgewandten Außenfläche der Zwischenschicht die Schutzdiodenstruktur in der der Trägerkörper zugewandten Außenfläche der Nutzschicht ausgebildet wird. Mit anderen Worten bildet die Schutzdiodenstruktur zumindest stellenweise eine Grenzfläche zwischen Nutzschicht und Zwischenschicht aus, wobei die Schutzdiodenstruktur nicht aus der Nutzschicht in umgekehrter vertikaler Richtung hervorragt. Mittels der Schutzdiodenstruktur ist der Halbleiterkörper vor elektrostatischer Entladung geschützt. Eine, beispielsweise aufgrund elektrostatischer Aufladung, entstehende, elektrische Spannung, die bezogen auf eine Durchlassrichtung der aktiven Zone in Sperrrichtung anliegt, kann über die Schutzdiodenstruktur abfließen. Eine Schädigung des Halbleiterkörpers beim späteren optoelektronischen Bauelement wird somit vermieden.

Es wird darüber hinaus ein elektrischer Anschlussträger angegeben.

Beispielsweise kann der elektrische Anschlussträger mittels des hier beschriebenen Verfahrens hergestellt werden, wie es in Verbindung mit einem oder mehreren der oben genannten Ausführungsformen beschrieben ist. Das heißt, die für das hier beschriebene Verfahren ausgeführten Merkmale sind auch für den hier beschriebenen elektrischen Anschlussträger offenbart und umgekehrt.

Gemäß zumindest einer Ausführungsform umfasst der elektrische Anschlussträger zumindest eine Nutzschicht, die eine Außenfläche und eine der Außenfläche gegenüberliegende Kontaktfläche aufweist. Die Kontaktfläche ist Teil des Außenflächeninhalts der Nutzschicht, wobei die Kontaktfläche einem Kontaktträger - beispielsweise eine Leiterplatte - im montierten Zustand des elektrischen Anschlussträgers zugewandt ist. Mit anderen Worten ist die Kontaktfläche eine Montagefläche, die zur Montage des elektrischen Anschlussträgers auf den Kontaktträger dienen kann. Zum Beispiel ist die Kontaktfläche stellenweise durch das elektrisch leitfähige Material gebildet. Dabei sind die Außenfläche der Nutzschicht und die Kontaktfläche über Seitenflächen des Anschlussträgers miteinander verbunden. Beispielsweise verlaufen die Seitenflächen des Anschlussträgers in vertikaler Richtung, also senkrecht oder quer zur Haupterstreckungsrichtung des elektrischen Anschlussträgers.

Gemäß zumindest einer Ausführungsform umfasst der elektrische Anschlussträger zumindest zwei in lateraler Richtung beabstandet zueinander angeordnete Öffnungen in der Nutzschicht, welche über die Außenfläche der Nutzschicht in der Nutzschicht eingebracht sind.

Gemäß zumindest einer Ausführungsform umfasst der elektrische Anschlussträger elektrisch leitfähiges Material, welches zumindest stellenweise in den Öffnungen angeordnet ist, wobei sich die Öffnungen ausgehend von der Außenfläche in Richtung der Kontaktfläche vollständig durch die Nutzschicht hindurch erstrecken.

Seitenflächen der Öffnungen und die Außenfläche der Nutzschicht sind elektrisch isolierend ausgebildet, wobei das elektrisch leitfähige Material in seinem Verlauf entlang der Außenfläche zwischen in lateraler Richtung benachbarten Öffnungen zumindest eine Unterbrechung aufweist.

Es wird darüber hinaus ein optoelektronisches Halbleiterbauelement angegeben.

Beispielsweise kann das optoelektronische Halbleiterbauelement mittels des hier beschriebenen Verfahrens hergestellt werden, wie es in Verbindung mit einem oder mehreren der oben genannten Ausführungsformen beschrieben ist. Das heißt, die für das hier beschriebene Verfahren ausgeführten Merkmale sind auch für das hier beschriebene optoelektronische Halbleiterbauelement offenbart und umgekehrt.

Das optoelektronische Halbleiterbauelement umfasst einen Anschlussträger, wie er in der oben beschriebenen Ausführungsform beschrieben ist. Das heißt, die für den elektrischen Anschlussträger ausgeführten Merkmale sind auch für das hier beschriebene optoelektronische Halbleiterbauelements offenbart und umgekehrt.

Das optoelektronische Halbleiterbauelement umfasst zumindest einen optoelektronischen Halbleiterkörper, der auf der Außenfläche der Nutzschicht angeordnet ist, wobei der optoelektronische Halbleiterkörper zumindest eine zur Erzeugung oder zur Detektion von elektromagnetischer Strahlung geeignete aktive Zone umfasst.

Das optoelektronische Halbleiterbauelement umfasst zumindest eine in der Nutzschicht ausgebildete Schutzdiodenstruktur, welche mit dem Halbleiterkörper elektrisch verschaltet ist.

Im Folgenden werden das hier beschriebene Verfahren sowie ein hier beschriebener elektrischer Anschlussträger und ein hier beschriebenes optoelektronisches Halbleiterbauelement anhand von Ausführungsbeispielen und den dazugehörigen Figuren näher erläutert.
- Die Figuren 1A, 1B, 1C, 1D, 1E und 1F: zeigen einzelne Fertigungsschritte zur Herstellung eines Ausführungsbeispiels eines hier beschriebenen optoelektronischen Halbleiterbauelements durch ein hier beschriebenes Verfahren, wobei
- die Figur 1F: in einer schematischen Seitenansicht ein Ausführungsbeispiel eines hier beschriebenen optoelektronischen Halbleiterbauelements umfassend ein Ausführungsbeispiel eines hier beschriebenen elektrischen Anschlussträgers zeigt.
- Die Figuren 2A, 2B und 2C: zeigen schematisch einzelne Fertigungsprozesse zur Herstellung eines Ausführungsbeispiels eines hier beschriebenen optoelektronischen Halbleiterbauelements.
- Die Figuren 3a und 3B: zeigen schematisch mögliche Ausführungsbeispiele der hier beschriebenen Kontaktschicht.
- Die Figur 4: zeigt schematisch ein Ausführungsbeispiel zur Beschichtung der Isolationsschicht im Bereich der Öffnungen mit einer Metalllage zur Verbesserung der Benetzung durch das elektrisch leitfähige Material.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

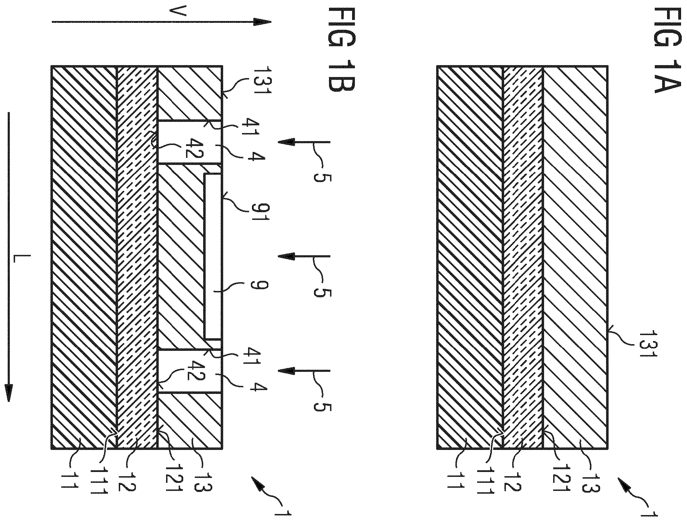

Die Figur 1A zeigt in einer schematischen Seitenansicht eine Trägeranordnung 1. Die Trägeranordnung 1 weist einen Trägerkörper 11, eine auf einer Außenfläche 111 des Trägerkörpers 11 angeordnete Zwischenschicht 12 sowie eine auf einer dem Trägerkörper 11 abgewandten Außenfläche 121 der Zwischenschicht 12 angeordnete Nutzschicht 13 auf. Insbesondere kann der Trägerkörper 11 mit einem Silizium und die Zwischenschicht mit einem Oxid des Siliziums und/oder einem Nitrid des Siliziums gebildet sein. Die Nutzschicht 13 ist mit zumindest einem der Materialien Si, N, GaN, Ge, GaAs gebildet oder enthält zumindest eines der Materialien. Beispielsweise weist die Nutzschicht 13 eine Dicke von wenigstens 30 µm bis höchstens 250 µm, bevorzugt wenigstens 50 µm bis höchstens 200 µm auf. "Dicke" heißt in diesem Zusammenhang eine maximale Ausdehnung der Nutzschicht 13 in vertikaler Richtung V.

Weiter ist in der Figur 1B in einer schematischen Seitenansicht der Trägeranordnung 1 erkennbar, dass in die Nutzschicht 13 über eine dem Träger 11 abgewandte Außenfläche 131 der Nutzschicht 13 in lateraler Richtung L beabstandet zueinander angeordnete Öffnungen 4 eingebracht sind, wobei Seitenflächen 41 der Öffnungen 4 vollständig durch die Nutzschicht 13 gebildet sind. Dabei sind die Öffnungen 4 beispielsweise mittels zumindest eines trocken- und/oder nasschemischen Ätzprozesses in der Nutzschicht 13 eingebracht. Mit anderen Worten wird in vertikaler Richtung V durch die Nutzschicht 13 während des Ätzens hindurch geätzt, wobei der Ätzprozess in der Zwischenschicht 12 endet und/oder durch das Material der Zwischenschicht 12 zum Erliegen gebracht wird. Das heißt, dass die Zwischenschicht 12 im Vergleich zur Nutzschicht 13 unter Verwendung des gleichen Ätzmittels im Wesentlichen nicht ätzbar ist. Bodenflächen 42 der Öffnungen 4 sind vollständig durch die Zwischenschicht 12 gebildet.

Weiter ist in der Figur 1B gezeigt, dass in der Nutzschicht 13 eine Schutzdiodenstruktur 9 ausgebildet ist. Dabei bilden die Außenfläche 131 und eine Außenfläche 91 der Schutzdiodenstruktur 9 eine ebene Fläche aus.

Zudem ist der Figur 1B ein thermisches Oxidationsverfahren 5 gezeigt, mittels dessen zumindest die Seitenflächen 41 und die dem Trägerkörper 11 abgewandte Außenfläche 131 der Nutzschicht 13 elektrisch isoliert werden. Mit anderen Worten wird direkt auf den oxidierter Stellen der Außenfläche 131 und den Seitenflächen 41 der Öffnungen 4 kein elektrischer Strom fließen oder entlang geleitet werden.

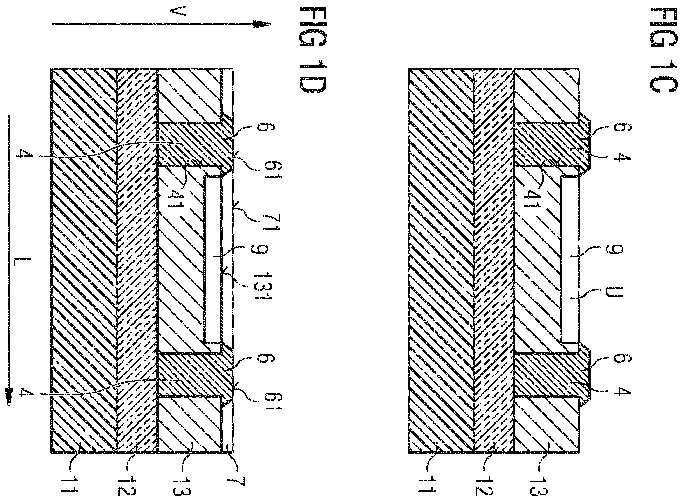

In der Figur 1C ist in einer schematischen Seitenansicht dargestellt, wie in einem nächsten Schritt elektrisch leitfähiges Material 6 in die Öffnungen 4 eingebracht, beispielsweise eingefüllt wird, wobei die Öffnungen 4 mit dem elektrisch leitfähigen Material 6 überfüllt werden. Das heißt, das elektrisch leitfähige Material 6 füllt die Öffnungen 4 vollständig aus und überragt die Nutzschicht 13 in vertikaler Richtung V. Dazu wird das elektrisch leitfähige Material 6 beispielsweise in Form einer Schmelze oder mittels eines galvanischen Prozesses in die Öffnungen 4 eingebracht.

Nach dem Einbringen in die Öffnungen 4 kann das elektrisch leitfähige Material 6 in den Öffnungen 4 aushärten. Beispielsweise kann eine Unterfüllung der Öffnungen 4 nach und/oder während dem Aushärten und/oder Abkühlen des elektrisch leitfähigen Materials 6 in den Öffnungen 4 durch eine Volumenkontraktion des elektrisch leitfähigen Materials 6 verursacht sein.

Wird versucht die Unterfüllung durch ein Dünnen der Nutzschicht 13 zu beheben, kann eine elektrische Isolation an einer oberen Kante der Nutschicht 13 Schaden nehmen, was zu einem Betriebs- und/oder Sicherheitsrisiko bei einer Verbauung der Nutzschicht 13 in einem Halbleiterbauelement führen kann. Überfüllung und beispielsweise nachträgliches Abtragen schont diese Kante und beispielsweise auf die Außenfläche 131 der Nutzschicht 13 aufgebrachte Sperr- und/oder Isolationsschichten 21. Derartige Sperr- und Isolationsschichten 21 können beispielsweise mittels chemischer Gasphasenabscheidung (zu engl.chemical vapour deposition, CVD) und/oder Atomlagenabscheidung (zu engl. atomic layer deposition, ALD) aufgebracht sein. Ebenso erlaubt die Zwischenschicht 12 ein Öffnen und/oder eine elektrische Anschlussausformung des elektrisch leitfähigen Materials 6 durch lokales Freilegen und/oder Öffnen des elektrisch leitfähigen Materials 6, ohne eine Kantenisolation der Öffnungen 4 zu gefährden. Zum Beispiel ist das elektrisch leitfähige Material 6 mit zumindest einem der Materialien Al, Zn, Cu, Ag, Si, Cd, Ga, In, Tl, Sn, Pb, Bi, Po gebildet oder enthält zumindest eines der Materialien. Neben den oben für das elektrisch leitfähige Material aufgezählten Materialien kann das elektrisch leitfähige Material insbesondere binäre eutektische Systeme, wie zum Beispiel AuSn, AuSi, AuGe, AuSb, AlGe und AlZn, umfassen. Weiter ist der Figur 1C entnehmbar, dass das elektrisch leitfähige Material 6 in seinem Verlauf entlang der Außenfläche 131 der Nutzschicht 13 in der lateralen Richtung L eine Unterbrechung U aufweist. Das heißt, dass zwischen den Öffnungen 4 und dem in den Öffnungen 4 angeordneten elektrisch leitfähigen Material 6 keine elektrisch leitende Verbindung hergestellt ist. Mit anderen Worten ist das in den Öffnungen 4 angeordnete elektrisch leitfähige Material 6 voneinander elektrisch isoliert.

In der Figur 1D ist einer schematischen Seitenansicht dargestellt, wie in einem nächsten Schritt eine Polierstoppschicht 7 auf die Außenfläche 131 aufgebracht wird, wobei dem Trägerkörper 11 abgewandte Außenflächen 61 des elektrisch leitfähigen Materials 6 stellenweise frei von der Polierstoppschicht 7 sind. Dabei ist in der Figur 1D bereits ein Polierschritt auf das elektrisch leitfähige Material 6 angewandt, sodass eine dem Trägerkörper 11 abgewandte Außenfläche 71 der Polierstoppschicht 7 und die Außenflächen 61 des elektrisch leitfähigen Materials 6 eine ebene Fläche ausbilden. Die Polierstoppschicht ist mit zumindest einer der Materialien SiO₂, Si₃N₄, SrO, HfO, HfO₂, ZrO, ZrO₂ gebildet oder enthält zumindest eines der Materialien.

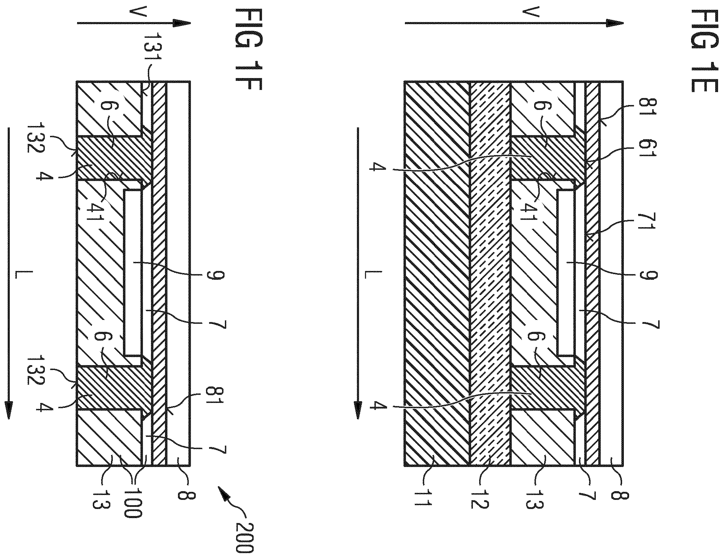

In der schematischen Seitenansicht der Figur 1E ist in einem nächsten Schritt dargestellt, wie auf der Außenfläche 71 der Polierstoppschicht 7 und den Außenflächen 61 des elektrisch leitfähigen Materials 6 ein Halbleiterkörper 8 aufgebracht wird, wobei der Halbleiterkörper 8 zumindest eine zur Erzeugung von elektromagnetischer Strahlung geeignete aktive Zone 81 umfasst. Beispielsweise basiert der Halbleiterkörper 8 auf einem III-Nitrid Halbleitermaterial. Der Halbleiterkörper 8 ist mit dem elektrisch leitfähigen Material 6 elektrisch leitend verbunden. Dazu kann der Halbleiterkörper 8 Kontaktstellen aufweisen, welche auf den Außenflächen 61 des elektrisch leitfähigen Materials 6 aufliegen und mit diesen beispielsweise in direktem Kontakt stehen. Insbesondere kann die Schutzdiodenstruktur 9 mit dem Halbleiterkörper 8 elektrisch verschaltet sein, wodurch der Halbleiterkörper 8 vor elektrostatischer Entladung geschützt ist.

In der schematischen Seitenansicht der Figur 1F ist dargestellt, dass von der Nutzschicht 13 sowohl der Trägerkörper 11 als auch die Zwischenschicht 12 vollständig entfernt sind und nach dem Entfernen des Trägerkörpers 11 und der Zwischenschicht 12 ein optoelektronisches Halbleiterbauelement 200 umfassend einen elektrischen Anschlussträger 100 hergestellt ist. Beispielsweise kann das Entfernen mittels Einwirkung von hochenergetischem Laserlicht auf die Zwischenschicht 12 geschehen, welche aufgrund des Laserlichts zumindest teilweise zerstört wird. Beispielsweise noch verbleibende Reste der Zwischenschicht 12 können mittels zumindest eines chemischen und/oder mechanischen Polierschritts von der Nutzschicht 13 entfernt werden. Das optoelektronische Halbleiterbauelement 200 weist eine der Außenfläche 131 gegenüberliegende Kontaktfläche 132 auf. Vorliegend ist die Kontaktfläche 132 stellenweise durch Außenflächen des elektrisch leitfähigen Materials 6 gebildet. Die Öffnungen 4 erstrecken sich ausgehend von der Außenfläche 131 in Richtung der Kontaktfläche 132 vollständig durch die Nutzschicht 13 hindurch.

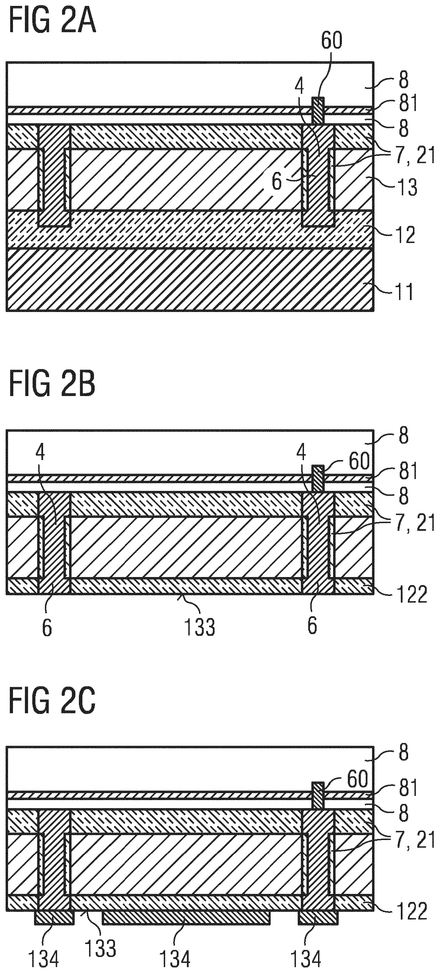

In der schematischen Seitenansicht der Figur 2A ist eine Vorstufe eines hier beschriebenen optoelektronischen Halbleiterbauelements 200 dargestellt. Die Trägerordnung 1 weist unter anderem die in lateraler Richtung zueinander beabstandet angeordnete Öffnungen 4 auf, die teilweise in die Zwischenschicht 12 hineinragen, wobei die Öffnungen 4 mit dem elektrisch leitfähigen Material 6 befüllt sind. Der optoelektronische Halbleiterkörper 8 ist auf der dem Trägerkörper 11 abgewandten Außenfläche der Nutzschicht 131 angeordnet, wobei die aktive Zone 81 des optoelektronischen Halbleiterkörper 8 mit dem elektrisch leitfähigen Material 6 durchdrungen ist und das elektrisch leitfähige Material 6 mit einem dotierten Bereich des optoelektronischen Halbleiterkörper 8 leitend angeschlossen ist.

In der schematischen Seitenansicht der Figuren 2B und 2C ist dargestellt, dass von der Nutzschicht 13 der Trägerkörper 11 vollständig und zumindest teilweise die Zwischenschicht 12 entfernt sind, dabei bildet das elektrisch leitfähige Material 6 mit der noch teilweise vorhandenen Zwischenschicht 12 eine Grenzfläche aus. Die Grenzfläche aus der Zwischenschicht 12 und elektrisch leitendem Material 6 bildet nun die Anschlussfläche 133 aus, die beispielsweise zur Verbindung mit einem Bauteilträger dienen kann. Anschlusssicht mit elektrisch leitendem Material, z.B. Lot gebildet.

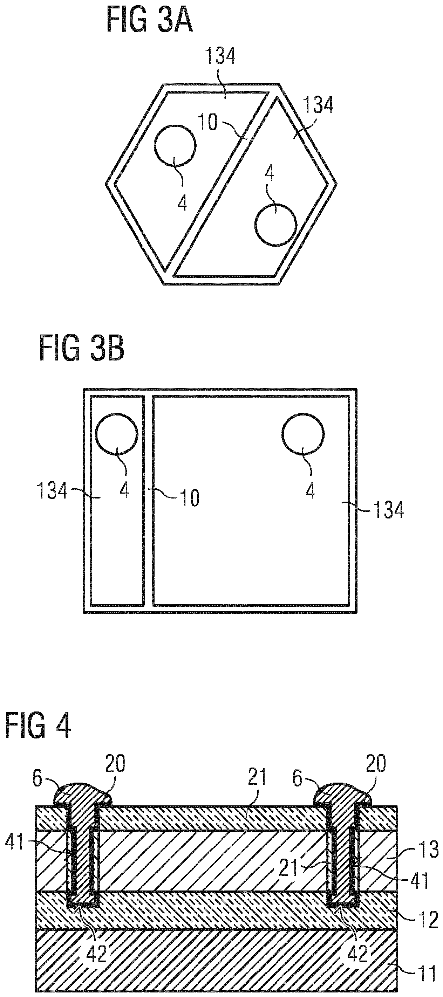

In der schematischen Draufsicht der Figur 3A und 3B sind jeweils Ausführungsbeispiele einer Kontaktschicht 134 dargestellt, die auf einer Anschlussfläche 133 ausbildet ist (siehe Figur 2C). Die Anschlussfläche 133 ist eine Grenzfläche, wobei die Grenzfläche aus dem elektrisch leitfähigen Material 6 und der Zwischenschicht 122 gebildet ist. Wie aus den beiden Ausführungsbeispielen ersichtlich ist, kann die Kontaktschicht 134 hexagonal oder rechteckig - ebenso wie das Bauelement - ausgebildet sein, wobei die Kontaktschicht 134 symmetrisch und/oder asymmetrisch ausgebildet sein kann Die Kontaktschicht 134 ist dabei im Bereich der Öffnungen 4 mit dem elektrisch leitfähigen Material 6 insbesondere durch einen Isolationsspalt 10 voneinander getrennt. Der Isolationsspalt 10 kann aus einem isolierenden Material bestehen und trennt die Kontaktschicht 134 derart, dass die Kontaktschicht zueinander elektrisch isolierende Bereiche und/oder Flächen aufweist.

In der schematischen Seitenansicht der Figur 4 ist im Ausführungsbeispiel die Beschichtung der Isolationsschicht 21 mit einer zusätzlichen Metalllage 20 dargestellt. Die Beschichtung durch die Metalllage 20 erfolgt im Bereich der Öffnungen 4, insbesondere an den Seitenflächen 41 und der Bodenfläche der Öffnungen 42 und auf der dem Trägerkörper 11 abgewandten Außenfläche der Nutzschicht 131 im Randbereich der Öffnungen, wobei die Metalllage in einer Draufsicht ringförmig ausbildet ist.

Die Erfindung ist nicht durch die Beschreibung anhand der Ausführungsbeispiele beschränkt.

## Patentansprüche

1. Verfahren zur Herstellung eines optoelektronischen Halbleiterbauelements (200) mit zumindest den folgenden Schritten:
- Bereitstellen einer Trägeranordnung (1), die einen Trägerkörper (11), eine auf einer Außenfläche (111) des Trägerkörpers (11) angeordnete elektrisch isolierende Zwischenschicht (12) und eine auf einer dem Trägerkörper (11) abgewandten Außenfläche (121) der Zwischenschicht (12) angeordnete Nutzschicht (13) aufweist;
- Einbringen von zumindest zwei in lateraler Richtung (L) beabstandet zueinander angeordneten Öffnungen (4) in die Nutzschicht (13) über eine dem Trägerkörper (11) abgewandte Außenfläche (131) der Nutzschicht (13), wobei sich die Öffnungen in vertikaler Richtung (V) vollständig durch die Nutzschicht (13) hindurch erstrecken und jede Öffnung (4) eine Bodenfläche (42) aufweist, die vollständig durch die Zwischenschicht (12) gebildet ist;
- Elektrisches Isolieren von Seitenflächen (41) der Öffnungen (4) und der dem Trägerkörper (11) abgewandten Außenfläche (131) der Nutzschicht (13);
- Anordnen von elektrisch leitfähigem Material (6) zumindest stellenweise in den Öffnungen (4), **gekennzeichnet dadurch dass**
- nach Fertigstellung des optoelektronischen Halbleiterbauelements (200) das elektrisch leitfähige Material (6) in seinem Verlauf entlang der Außenfläche (131) der Nutzschicht (13) in der lateralen Richtung (L) zwischen benachbarten Öffnungen (4) zumindest eine Unterbrechung (U) aufweist,
- Anordnen von zumindest einem optoelektronischen Halbleiterkörper (8) auf der Außenfläche (131) der Nutzschicht (13), wobei der optoelektronische Halbleiterkörper (8) zumindest eine zur Erzeugung oder zur Detektion von elektromagnetischer Strahlung geeignete aktive Zone (81) umfasst, und mit dem elektrisch leitfähigen Material (6) elektrisch leitend verbunden ist, und
- Ausbilden von zumindest einer Schutzdiodenstruktur (9) in der Nutzschicht (13), wobei die Schutzdiodenstruktur (9) mit dem Halbleiterkörper (8) elektrisch verschaltet ist.

2. Verfahren nach Anspruch 1,
bei dem der Trägerkörper (11) mit einem Silizium gebildet ist und die Zwischenschicht (12) mit einem Oxid des Siliziums und/oder einem Nitrid des Siliziums gebildet ist.

3. Verfahren nach einem der vorhergehenden Ansprüche,
bei dem die Nutzschicht (13) mit zumindest einem der Materialien gebildet ist oder zumindest eines der Materialien enthält: Si, N, GaN, Ge, GaAs.

4. Verfahren nach einem der vorhergehenden Ansprüche,
bei dem das elektrische Isolieren mittels zumindest eines thermischen Oxidationsverfahrens (5) durchgeführt wird.

5. Verfahren nach einem der vorhergehenden Ansprüche,
bei dem das elektrisch leitfähige Material (6) in Form einer Schmelze in die Öffnungen (4) eingebracht wird und anschließend aushärtet, wobei
- das elektrisch leitfähige Material (6) mit zumindest einem der folgenden Materialien gebildet ist oder zumindest eines der folgenden Materialien enthält: Al, Zn, Cu, Ag, Si, Cd, Ga, In, Tl, Sn, Pb, Bi, Po und/oder,
- das elektrisch leitfähige Material zumindest ein binäres eutektisches System umfasst.

6. Verfahren nach einem der vorhergehenden Ansprüche,
bei dem nach dem Aushärten das elektrisch leitfähige Material (6) die Nutzschicht (13) in vertikaler Richtung (V) überragt.

7. Verfahren nach einem der vorhergehenden Ansprüche,
bei dem auf die dem Trägerkörper (11) abgewandte Außenfläche (131) der Nutzschicht (13) zumindest stellenweise zumindest eine Polierstoppschicht (7) aufgebracht wird, wobei dem Trägerkörper (11) abgewandte Außenflächen (61) des elektrisch leitfähigen Materials (6) zumindest stellenweise frei von der Polierstoppschicht (7) sind und die Polierstoppschicht (7) mit zumindest einem der folgenden Materialien gebildet ist oder zumindest eines der folgenden Materialien enthält: SiO₂, Si₃N₄, SrO, HfO, HfO₂, ZrO, ZrO₂.

8. Verfahren nach dem vorhergehenden Anspruch,
bei dem nach Anwendung zumindest eines Polierschritts zumindest auf das elektrisch leitfähige Material (6), das elektrisch leitfähige Material (6) die Polierstoppschicht (7) in vertikaler Richtung (V) nicht überragt.

9. Verfahren nach einem der vorhergehenden Ansprüche,
bei dem nach dem Anordnen des elektrisch leitfähigen Materials (6) der Trägerkörper (11) von der Zwischenschicht (12) entfernt wird.

10. Verfahren nach einem der vorhergehenden Ansprüche, bei dem die Nutzschicht (13) des Trägerkörpers (11) eine Dicke von wenigstens 30 µm und höchstens 250 µm hat.

11. Verfahren nach dem vorhergehenden Anspruch, wobei ein weiteres elektrisch leitfähige Material (60) die aktive Zone (81) des optoelektronischen Halbleiterkörpers (8) durchdringt und ein dotierter Bereich des optoelektronischen Halbleiterkörpers (8) elektrisch leitend mit dem elektrisch leitfähigen Material (6) des elektrischen Anschlussträgers (100) angeschlossen ist.

12. Optoelektronisches Halbleiterbauelement (200) mit
- einem elektrischen Anschlussträger (100) umfassend
- zumindest eine Nutzschicht (13), die eine Außenfläche (131) und eine der Außenfläche (131) gegenüberliegende Kontaktfläche (132) aufweist;
- zumindest zwei in lateraler Richtung (L) beabstandet zueinander angeordnete Öffnungen (4) in der Nutzschicht (13), welche über die Außenfläche (131) der Nutzschicht (13) in die Nutzschicht (13) eingebracht sind, wobei
sich die Öffnungen (4) ausgehend von der Außenfläche (131) in Richtung der Kontaktfläche (132) vollständig durch die Nutzschicht (13) hindurch erstrecken und jede Öffnung (4) eine Bodenfläche (42) aufweist, die vollständig durch eine elektrisch isolierende Zwischenschicht (12) gebildet ist,
- elektrisch leitfähigem Material (6), welches zumindest stellenweise in den Öffnungen (4) angeordnet ist,
- zumindest einen optoelektronischen Halbleiterkörper (8), der auf der Außenfläche (131) der Nutzschicht (13) angeordnet ist, wobei der optoelektronische Halbleiterkörper (8) zumindest eine zur Erzeugung oder zur Detektion von elektromagnetischer Strahlung geeignete aktive Zone (81) umfasst,
- zumindest eine in der Nutzschicht (13) ausgebildeten Schutzdiodenstruktur (9), welche mit dem Halbleiterkörper (8) elektrisch verschaltet ist, wobei
Seitenflächen (41) der Öffnungen (4) und die Außenfläche (131) der Nutzschicht (13) elektrisch isolierend ausgebildet sind, und wobei
das elektrisch leitfähige Material (6) in seinem Verlauf entlang der Außenfläche (131) zwischen in lateraler Richtung (L) benachbarten Öffnungen (4) zumindest eine Unterbrechung (U) aufweist.

13. Optoelektronisches Halbleiterbauelement (200) nach Anspruch 12, wobei
- die Schutzdiodenstruktur (9) zwischen den zumindest zwei Öffnungen (4) angeordnet ist und eine Außenfläche (91) der Schutzdiodenstruktur (9) mit der Außenfläche (131) der Nutzschicht (13) eine ebene Fläche bildet
- das elektrisch leitfähige Material (6) auf der Außenfläche (131) der Nutzschicht (13) lateral über die zumindest zwei Öffnungen (4) hinausragt.

## Claims

1. A method for producing an optoelectronic semiconductor device (200) comprising at least the following steps:
- Providing a carrier arrangement (1) comprising a carrier body (11), an electrically insulating intermediate layer (12) arranged on an outer surface (111) of the carrier body (11) and a utility layer (13) arranged on an outer surface (121) of the intermediate layer (12) facing away from the carrier body (11);
- Inserting of at least two openings (4) arranged at a distance from one another in the lateral direction (L) into the utility layer (13) via an outer surface (131) of the utility layer (13) facing away from the carrier body (11), wherein the openings extend completely through the utility layer (13) in the vertical direction (V) and each opening (4) comprises a bottom surface (42) which is formed completely by the intermediate layer (12);
- Electrically insulating side surfaces (41) of the openings (4) and the outer surface (131) of the utility layer (13) facing away from the carrier body (11);
- Arranging electrically conductive material (6) at least in places in the openings (4), **characterized in that**
- after completion of the optoelectronic semiconductor component (200), the electrically conductive material (6) comprises at least one interruption (U) in its course along the outer surface (131) of the utility layer (13) in the lateral direction (L) between adjacent openings (4),
- Arranging at least one optoelectronic semiconductor body (8) on the outer surface (131) of the utility layer (13), the optoelectronic semiconductor body (8) comprising at least one active zone (81) suitable for generating or detecting electromagnetic radiation, and being electrically conductively connected to the electrically conductive material (6), and
- Forming at least one protective diode structure (9) in the utility layer (13), the protective diode structure (9) being electrically connected to the semiconductor body (8).

2. Method according to claim 1,
in which the carrier body (11) is formed with a silicon and the intermediate layer (12) is formed with an oxide of the silicon and/or a nitride of the silicon.

3. Method according to any one of the preceding claims,
in which the utility layer (13) is formed with at least one of the materials or contains at least one of the materials: Si, N, GaN, Ge, GaAs.

4. Method according to any one of the preceding claims,
in which the electrical insulation is carried out by means of at least one thermal oxidation process (5).

5. Method according to any one of the preceding claims,
in which the electrically conductive material (6) is introduced into the openings (4) in the form of a melt and subsequently hardens, wherein
- the electrically conductive material (6) is formed with at least one of the following materials or contains at least one of the following materials: Al, Zn, Cu, Ag, Si, Cd, Ga, In, Tl, Sn, Pb, Bi, Po and/or,
- the electrically conductive material comprises at least one binary eutectic system.

6. Method according to any one of the preceding claims,
in which, after curing, the electrically conductive material (6) projects beyond the utility layer (13) in the vertical direction (V).

7. Method according to any one of the preceding claims,
in which at least one polishing stop layer (7) is applied at least in places to the outer surface (131) of the utility layer (13) facing away from the carrier body (11), wherein outer surfaces (61) of the electrically conductive material (6) facing away from the carrier body (11) are at least in places free of the polishing stop layer (7) and the polishing stop layer (7) is formed with at least one of the following materials or contains at least one of the following materials: SiO₂, Si₃N₄, SrO, HfO, HfO₂, ZrO, ZrO₂.

8. Method according to the preceding claim,
in which, after at least one polishing step has been applied to at least the electrically conductive material (6), the electrically conductive material (6) does not protrude beyond the polishing stop layer (7) in the vertical direction (V).

9. Method according to any one of the preceding claims,
in which the carrier body (11) is removed from the intermediate layer (12) after the electrically conductive material (6) has been arranged.

10. Method according to any one of the preceding claims,
wherein the utility layer (13) of the carrier body (11) has a thickness of at least 30 µm and at most 250 µm.

11. Method according to the preceding claim, wherein a further electrically conductive material (60) penetrates the active zone (81) of the optoelectronic semiconductor body (8) and a doped region of the optoelectronic semiconductor body (8) is electrically conductively connected to the electrically conductive material (6) of the electrical connection carrier (100).

12. Optoelectronic semiconductor component (200) with
- an electrical connection carrier (100) comprising
- at least one utility layer (13), which has an outer surface (131) and a contact surface (132) opposite the outer surface (131);
- at least two openings (4) in the utility layer (13), which are arranged spaced apart from one another in the lateral direction (L) and are introduced into the utility layer (13) via the outer surface (131) of the utility layer (13),
wherein
the openings (4) extend from the outer surface (131) in the direction of the contact surface (132) completely through the utility layer (13) and each opening (4) has a bottom surface (42) which is completely formed by an electrically insulating intermediate layer (12),
- electrically conductive material (6), which is arranged at least in places in the openings (4),
- at least one optoelectronic semiconductor body (8), which is arranged on the outer surface (131) of the utility layer (13), the optoelectronic semiconductor body (8) comprising at least one active zone (81) suitable for generating or detecting electromagnetic radiation,
- at least one protective diode structure (9) which is formed in the utility layer (13) and which is electrically connected to the semiconductor body (8), wherein
side surfaces (41) of the openings (4) and the outer surface (131) of the utility layer (13) are electrically insulating, and wherein
the electrically conductive material (6) has at least one interruption (U) in its course along the outer surface (131) between openings (4) adjacent in the lateral direction (L).

13. Optoelectronic semiconductor component (200) according to claim 12, wherein
- the protective diode structure (9) is arranged between the at least two openings (4) and an outer surface (91) of the protective diode structure(9) forms a flat surface with the outer surface (131) of the utility layer (13)
- the electrically conductive material (6) on the outer surface (131) of the utility layer (13) projects laterally beyond the at least two openings (4).

## Revendications

1. Procédé de fabrication d'un dispositif optoélectronique à semi-conducteur (200) comprenant au moins les étapes suivantes :
- Mise à disposition d'un dispositif de support (1) qui présente un corps de support (11), une couche intermédiaire (12) électriquement isolante disposée sur une surface extérieure (111) du corps de support (11) et une couche utile (13) disposée sur une surface extérieure (121) de la couche intermédiaire (12) opposée au corps de support (11) ;
- introduction d'au moins deux ouvertures (4) disposées à distance l'une de l'autre dans la direction latérale (L) dans la couche utile (13) par l'intermédiaire d'une surface extérieure (131) de la couche utile (13) opposée au corps de support (11), les ouvertures s'étendant entièrement à travers la couche utile (13) dans la direction verticale (V) et chaque ouverture (4) présentant une surface de fond (42) qui est entièrement formée par la couche intermédiaire (12) ;
- isoler électriquement les surfaces latérales (41) des ouvertures (4) et la surface extérieure (131) de la couche utile (13) qui est opposée au corps de support (11) ;
- Disposition d'un matériau électriquement conducteur (6) au moins par endroits dans les ouvertures (4), **caractérisée en ce que**
- après l'achèvement du composant semi-conducteur optoélectronique (200), le matériau électriquement conducteur (6) présente au moins une interruption (U) dans son parcours le long de la surface extérieure (131) de la couche utile (13) dans la direction latérale (L) entre des ouvertures (4) voisines,
- disposer au moins un corps semi-conducteur optoélectronique (8) sur la surface extérieure (131) de la couche utile (13), le corps semi-conducteur optoélectronique (8) comprenant au moins une zone active (81) appropriée pour la génération ou la détection de rayonnement électromagnétique, et étant relié de manière électriquement conductrice au matériau électriquement conducteur (6), et
- la formation d'au moins une structure de diode de protection (9) dans la couche utile (13), la structure de diode de protection (9) étant connectée électriquement au corps semi-conducteur (8).

2. Procédé selon la revendication 1,
dans lequel le corps de support (11) est formé avec un silicium et la couche intermédiaire (12) est formée avec un oxyde du silicium et/ou un nitrure du silicium.

3. Procédé selon l'une quelconque des revendications précédentes,
dans lequel la couche utile (13) est formée avec au moins l'un des matériaux ou contient au moins l'un des matériaux : Si, N, GaN, Ge, GaAs.

4. Procédé selon l'une quelconque des revendications précédentes,
dans lequel l'isolation électrique est réalisée au moyen d'au moins un procédé d'oxydation thermique (5).

5. Procédé selon l'une quelconque des revendications précédentes,
dans lequel le matériau électriquement conducteur (6) est introduit sous la forme d'une masse fondue dans les ouvertures (4) et est ensuite durci, dans lequel
- le matériau électriquement conducteur (6) est formé avec au moins l'un des matériaux suivants ou contient au moins l'un des matériaux suivants : Al, Zn, Cu, Ag, Si, Cd, Ga, In, Tl, Sn, Pb, Bi, Po et/ou,
- le matériau électriquement conducteur comprend au moins un système eutectique binaire.

6. Procédé selon l'une quelconque des revendications précédentes,
dans lequel, après le durcissement, le matériau électriquement conducteur (6) dépasse la couche utile (13) dans le sens vertical (V).

7. Procédé selon l'une quelconque des revendications précédentes,
dans lequel au moins une couche d'arrêt de polissage (7) est appliquée au moins par endroits sur la surface extérieure (131) de la couche utile (13) opposée au corps de support (11), les surfaces extérieures (61) du matériau électriquement conducteur (6) opposées au corps de support (11) étant au moins par endroits exemptes de la couche d'arrêt de polissage (7) et la couche d'arrêt de polissage (7) étant formée avec au moins un des matériaux suivants ou contenant au moins un des matériaux suivants SiO₂, Si₃N₄, SrO, HfO, HfO₂, ZrO, ZrO₂.

8. Procédé selon la revendication précédente,
dans lequel, après application d'au moins une étape de polissage au moins sur le matériau électriquement conducteur (6), le matériau électriquement conducteur (6) ne dépasse pas la couche d'arrêt de polissage (7) dans la direction verticale (V).

9. Procédé selon l'une quelconque des revendications précédentes,
dans lequel, après la mise en place du matériau électriquement conducteur (6), le corps de support (11) est retiré de la couche intermédiaire (12).

10. Procédé selon l'une quelconque des revendications précédentes, dans lequel la couche utile (13) du corps de support (11) a une épaisseur d'au moins 30 µm et d'au plus 250 µm.

11. Procédé selon la revendication précédente, dans lequel un autre matériau électriquement conducteur (60) traverse la zone active (81) du corps semi-conducteur optoélectronique (8) et une zone dopée du corps semi-conducteur optoélectronique (8) est raccordée de manière électriquement conductrice au matériau électriquement conducteur (6) du support de connexion électrique (100).

12. Dispositif semi-conducteur optoélectronique (200) comprenant
- un support de connexion électrique (100) comprenant
- au moins une couche utile (13), qui présente une surface extérieure (131) et une surface de contact (132) opposée à la surface extérieure (131) ;
- au moins deux ouvertures (4) dans la couche utile (13), disposées à distance l'une de l'autre dans la direction latérale (L), qui sont pratiquées dans la couche utile (13) par l'intermédiaire de la surface extérieure (131) de la couche utile (13), dans lequel
les ouvertures (4) s'étendent complètement à travers la couche utile (13) en partant de la surface extérieure (131) en direction de la surface de contact (132) et chaque ouverture (4) présente une surface de fond (42) qui est entièrement formée par une couche intermédiaire (12) électriquement isolante,
- matériau électriquement conducteur (6), qui est disposé au moins par endroits dans les ouvertures (4),
- au moins un corps semi-conducteur optoélectronique (8), qui est disposé sur la surface extérieure (131) de la couche utile (13), le corps semi-conducteur optoélectronique (8) comprenant au moins une zone active (81) appropriée à la génération ou à la détection de rayonnement électromagnétique,
- au moins une structure de diode de protection (9) formée dans la couche utile (13), qui est connectée électriquement au corps semi-conducteur (8), où
les surfaces latérales (41) des ouvertures (4) et la surface extérieure (131) de la couche utile (13) sont réalisées de manière à être électriquement isolantes, et dans lequel le matériau électriquement conducteur (6) présente au moins une interruption (U) dans son parcours le long de la surface extérieure (131) entre des ouvertures (4) voisines dans la direction latérale (L).

13. Dispositif semi-conducteur optoélectronique (200) selon la revendication 12, dans lequel
- la structure de diode de protection (9) est disposée entre les au moins deux ouvertures (4) et une surface extérieure (91) de la structure de diode de protection(9) forme une surface plane avec la surface extérieure (131) de la couche utile (13)
- le matériau électriquement conducteur (6) fait saillie latéralement sur la surface extérieure (131) de la couche utile (13) au-delà des au moins deux ouvertures (4).
